(19) Europäisches Patentamt

European Patent Office

Office européen des brevets

(11) Numéro de publication : **0 298 850 B1**

(12) **FASCICULE DE BREVET EUROPEEN**

(45) Date de publication du fascicule du brevet :
**04.03.92 Bulletin 92/10**

(21) Numéro de dépôt : **88401719.5**

(22) Date de dépôt : **01.07.88**

(51) Int. Cl.⁵ : **G01R 33/56**

(54) **Procédé d'élimination d'artefacts dans une expérimentation d'imagerie par RMN.**

Le dossier contient des informations techniques présentées postérieurement au dépôt de la demande et ne figurant pas dans le présent fascicule.

(30) Priorité : **10.07.87 FR 8709813**

(43) Date de publication de la demande :
**11.01.89 Bulletin 89/02**

(45) Mention de la délivrance du brevet :
**04.03.92 Bulletin 92/10**

(84) Etats contractants désignés :
**DE ES GB IT NL**

(56) Documents cités :
**EP-A- 0 100 183**
**GB-A- 2 056 078**

(73) Titulaire : **GENERAL ELECTRIC CGR S.A.**
**13, Square Max-Hymans**
**F-75015 Paris (FR)**

(72) Inventeur : **Le Roux, Patrick**
**Cabinet Ballot-Schmit 84, Avenue Kléber**
**F-75116 Paris (FR)**

(74) Mandataire : **Schmit, Christian Norbert Marie et al**
**Cabinet Ballot-Schmit 7, rue Le Sueur**
**F-75116 Paris (FR)**

## Description

La présente invention a pour objet un procédé d'élimination d'artefacts dans une expérimentation d'imagerie par résonance magnétique nucléaire RMN. Elle trouve plus particulièrement son application dans le domaine médical où on cherche à représenter les images de coupes de corps humains étudiés. Dans ces images, elle sert plus particulièrement à éliminer les perturbations résultant d'artéfacts dit de bougé causés par des mouvements des corps ou dans les corps.

La représentation des objets en mouvement passe d'une manière classique par la saisie de clichés, cliché étant entendu au sens large, successifs régulièrement répartis dans le temps au cours du mouvement à étudier. La visualisation de ces clichés, à un rythme ralenti, permet de bien étudier le mouvement de l'objet. Les procédés de télévision moderne permettent, avec des caméras, de mettre en oeuvre cette technique dans la mesure où les caméras sont suffisamment rapides pour acquérir des images très proches les unes des autres dans le temps, et dans la mesure où on visualise par la suite les images en ralentissant le rythme de projection. Ces techniques générales malheureusement ne sont pas applicables facilement aux procédés d'imagerie par RMN.

En effet, l'acquisition d'images de type tomographique avec de tels appareils n'est obtenue qu'après un traitement de reconstruction des images des coupes. Par exemple, les particules du corps d'un patient à étudier situées dans la coupe sont soumises à une excitation au cours de l'expérimentation. Elle restituent à l'issue un signal qui comporte une information représentative de leur nature. Malheureusement toutes les particules de la coupe réémettent un signal en même temps. Avec les procédés de reconstruction d'images connus, en particulier le procédé de reconstruction dit 2DFT, on tourne la difficulté de cette réponse simultanée en réitérant un certain nombre de fois les expérimentations et en changeant, d'une expérimentation à une autre, au cours de séquences d'excitation-mesure, les conditions d'acquisition du signal. Typiquement en imagerie par RMN on effectue 256 expérimentations successives pendant une durée totale qui, au plus court, avoisine la demi-minute. Or les cycles de fluctuation du corps humain, par exemple à l'endroit du coeur sont beaucoup plus rapides. Il en résulte que l'ensemble des séquences est acquis pendant une durée plus longue que celle de la pulsation cardiaque par exemple A l'endroit du coeur les images sont alors brouillées.

Pour remédier à cet inconvénient de bougé on a, dans un premier temps, effectué des synchronisations. Cependant en RMN, les procédés d'excitation les plus rapides (dit SSFP, Steady State Free Precession) qui correspondent à une précession libre en régime d'équilibre des moments magnétiques des particules doivent être appliqués à un rythme propre. Ce rythme propre dépend du temps de relaxation spin-spin, dit $T_2$, des moments magnétiques des particules étudiées. Ce rythme propre s'oppose bien entendu à la synchronisation. Il n'y a en effet aucune raison pour que ce rythme propre soit un multiple du rythme cardiaque. Si on synchronise (et si donc on abandonne l'idée du mode SSFP), et qu'en plus on veuille faire une image dit en $T_2$ (pour montrer les temps de relaxation spin-spin), il faut alors attendre entre chaque expérimentation une durée égale à 3 ou 4 fois la durée $T_1$ (temps de relaxation spin-réseau) caractéristique des particules étudiées. Autrement dit chaque expérimentation dure de l'ordre de 2 secondes. L'acquisition de 256 séquences conduit alors à une durée, pour une seule image synchronisée pendant le cycle cardiaque, d'environ 10 minutes compte tenu des pertes de temps lors des synchronisations. Or les médecins pour pouvoir bien comprendre le fonctionnement du coeur, demandent de disposer d'environ 32 images pour un cycle cardiaque complet. Ceci conduit à une durée totale d'examen de 5 heures. Cette durée est tout à fait insupportable pour les patients. En outre, même si ces patients la supportaient, le cycle cardiaque n'est pas constant. De sorte que la synchronisation, effectuée par rapport à une date précise du cycle, des autres instants de ce cycle ne correspond pas toujours à un même état du coeur. L'avance ou le retard de phase par rapport à un état prédéterminé du coeur dépendent de l'accélération ou du ralentissement du rythme cardiaque par rapport à un rythme cardiaque nominal estimé. Il en résulte que les images présentent des artefacts.

Dans un mode d'excitation en variante, dit $T_2$ rapide avec faible basculement, et en synchronisant on peut aller beaucoup plus vite puisque typiquement un cycle $T_2$ rapide dure environ 50 millisecondes. De sorte que l'on peut acquérir une deuxième phase du cycle cardiaque sur une durée sensiblement égale à deux fois ce cycle. En imagerie avec résolution normale (256 séquences par phase de cycle), ceci conduit à une durée totale de l'expérimentation de 4 minutes. Mais l'imagerie $T_2$ rapide ne peut pas être menée systématiquement dans une même tranche : le signal de RMN s'y amortit trop, on perd en contraste. On utilise alors une technique multicoupe : pendant des temps morts pour laisser renaître le signal on effectue des mesures dans d'autres coupes. Pratiquement l'expérimentation dure alors quatre fois plus longtemps : 40 minutes. C'est aussi bien trop long. De plus le même problème de synchronisation que ci-dessus se présente. Lorsque la fréquence cardiaque n'est pas constante (pendant 40 minutes!), les images présentent aussi des artefacts.

Une autre technique a été imaginée par Michaël L. WOOD et R. Marc HENKELMAN du ONTARIO CANCER INSTITUTE AND DEPARTMENT OF MEDICAL BIOPHYSICS, UNIVERSITY OF TORONTO, CANADA.

Elle a été publiée dans Medical Physics, volume 13, numéro 6 de Novembre/Décembre 1986. Elle consiste, pour l'essentiel à effectuer une moyenne sur plusieurs images successives, en vue d'éliminer des artefacts de bougé. Mais cette technique d'imagerie, qui s'intéresse à l'élimination des effets des mouvements n'est pas totalement efficace, et certains parasites restent dans l'image. La raison du maintien de ces parasites est liée encore une fois à la variation du cycle cardiaque au cours de l'expérimentation.

Dans l'invention on remédie à ces inconvénients en utilisant les avantages d'un procédé particulier de reconstruction d'images : le procédé dit 2DFT. Dans ce procédé 2DFT, au cours de chaque séquence, une excitation est suivie avant la mesure du signal de RMN résultant d'une période au cours de laquelle on applique à la partie étudiée dans le corps un gradient de champ magnétique ayant une fonction de codage de phase du signal de RMN. La valeur de ce gradient évolue pas à pas au fur et à mesure de l'exécution des séquences nécessaires à la reconstruction de l'image selon ce procédé. On peut montrer que le choix du pas du gradient est totalement lié à la dimension du volume étudié, mesurée selon l'orientation de l'axe d'application de ce gradient de codage. Ce gradient de codage de phase a pour effet de déphaser, dans le signal reçu, les contributions au signal de RMN global des différentes parties du corps en fonction de leurs abcisses mesurées dans le volume étudié selon cet axe de gradient de codage. En pratique la résolution significative de l'image obtenue dépend du nombre de séquences entreprises et au cours desquelles le gradient de codage de phase varie pas à pas.

Dans l'invention on décide d'utiliser un pas de variation du gradient de codage de phase qui est un sous multiple. Dans un exemple préféré, et pour fixer les idées uniquement, le pas de variation du gradient de codage de phase est huit fois inférieur au pas normal. Il en résulte que le champ image décrit a, selon la direction de ce gradient de codage de phase, une dimension huit fois plus grande que le champ image classique. Autrement dit au lieu d'étudier ce qui se passe sur une hauteur, par exemple de 30 cm selon cet axe de codage de phase, on cherche à savoir ce qui se passe sur une hauteur multiple de 240 cm : là où en définitive il n'y a rien. Pour obtenir une image avec la même résolution dans les 30 cm utile, il est alors nécessaire de décrire cette image, huit fois plus haute, par huit fois plus de séquences. Dans un exemple pratique pour aboutir à une résolution de 256 lignes dans l'image utile, il est alors nécessaire d'exécuter 8 x 256 = 2048 séquences successives.

On montre alors que par traitement de Fourier on peut reconstruire une image représentative de ce qui n'est que fixe dans le corps sous examen. Ce résultat est alors obtenu quelle que soit l'évolution de la durée du cycle de la partie qui pourrait être cycliquement en mouvement (le coeur) dans le corps étudié. Il en résulte que les images des parties fixes ne sont maintenant plus dépendantes de la variation du cycle cardiaque. On montrera qu'en pratique il n'est nécessaire , pour aboutir à cette image des parties fixes, que de ne reconstituer qu'en partie l'image significative (par exemple, par une transformée de Fourier à 256 fois 8 points, pour obtenir une image réduite aux 256 lignes utiles).

L'invention concerne donc un procédé d'élimination d'artefacts dans une expérimentation d'imagerie par RMN, dans laquelle on met en oeuvre un procédé d'imagerie de type 2DFT, avec un pas de codage de phase prédeterminé par une image de dimension donnée à obtenir, et avec un nombre de séquences prédéterminé par une résolution significative attendue, caractérisé en ce qu'on modifie le pas de codage de phase en en prenant un sous multiple et en ce qu'on multiplie en correspondance de nombre de séquences pour correspondre à une image de même résolution mais de dimension multiple selon une direction correspondant à ce codage de phase.

L'invention sera mieux comprise à la lecture de la description qui suit et à l'examen des figures qui l'accompagnent. Celles ci ne sont données qu'à titre indicatif et nullement limitatif de l'invention. Les figures montrent :
– figure 1 : une machine de RMN utilisable pour la mise en oeuvre du procédé selon l'invention;
– figure 2a à 2d : une représentation schématique des principales phases d'un procédé d'imagerie de type 2DFT;
– figure 3 : la représentation schématique de la modification résultant de l'invention dans le procédé d'imagerie concerné;
– figure 4 à 6 : des représentations schématiques des significations des images obtenues respectivement dans l'état de la technique et avec le procédé de l'invention.
– figures 7a et 7b : des variantes du procédé selon l'invention.

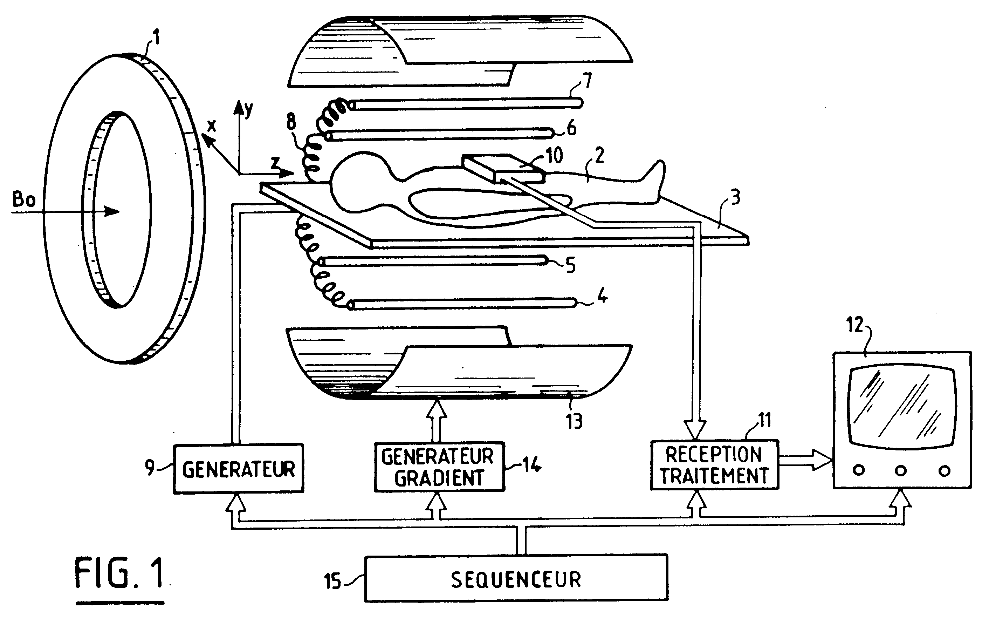

La figure 1 montre une machine utilisable pour la mise en oeuvre du procédé selon l'invention. Cette machine comporte essentiellement des moyens, symbolisés par une bobine 1, pour produire un champ magnétique uniforme intense $B_O$ dans une région où est placé le corps 2 d'un patient, au dessus d'un plateau 3. Soumis à cette aimantation, les moments magnétiques des particules du corps 2 s'orientent selon la direction du champ uniforme $B_O$. Dans cette situation on soumet en outre le corps 2 à une excitation électromagnétique radiofréquence transmise par une antenne, par exemple à barres rayonnantes 4 à 7, alimentée au travers d'un circuit rayonnant 8 par un générateur d'excitations 9. A l'issue de l'excitation, une antenne de réception 10 permet de prélever le signal de désexcitation qui marque le retour à l'équilibre des moments magnétiques des particules du corps 2. L'antenne de réception peut d'ailleurs être confondue avec l'antenne d'émission. Le signal reçu est traité dans un récepteur 11 en vue de la visualisation, sur un dispositif de visualisation 12, d'une image d'une coupe du corps 2. De manière à discriminer dans le signal reçu les contributions pour chacun des éléments de volume de la coupe, une série d'expérimentations est entreprise. Au cours de chacune des expérimentations, des codages magnétiques de l'espace où est situé le corps 2 sont imposés à des valeurs différentes par des champs magnétiques supplémentaires appliqués par des bobines 13 dites de gradient. Ces bobines de gradient sont alimentées par un générateur d'impulsions de gradient 14. L'ensemble de ces moyens fonctionne sous la conduite d'un séquenceur 15.

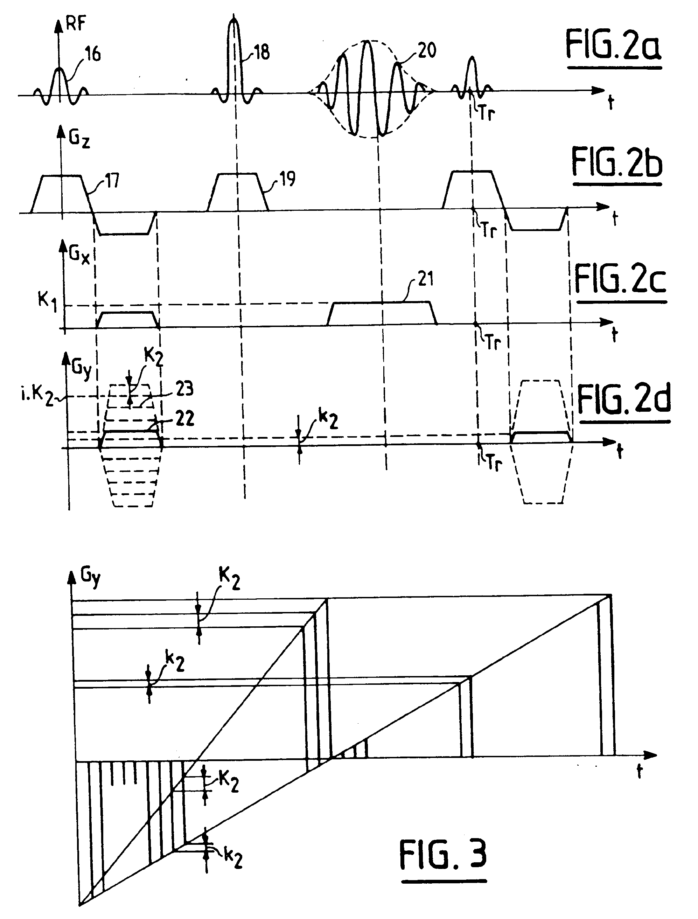

Dans la pratique on retient que l'image peut être reconstruite selon un procédé de reconstruction dit 2DFT, dont les figures 2 donnent un aperçu des phases principales. Un excitation radiofréquence 16 est appliquée en présence d'une impulsion 17 de gradient de sélection de coupe (axe Z). Une impulsion radiofréquence 18 dite d'écho de spin est émise ultérieurement en présence d'une impulsion 19 d'un même gradient de sélection de coupe, pour sélectionner la même coupe et pour éliminer des défauts d'homogénéité du champ $B_O$. Pendant la réception du signal 20 de désexcitation, une impulsion 21 d'un gradient dit de lecture est appliqué (axe X). Entre l'impulsion 16 et l'impulsion 18, un codage de phase 22 du signal de RMN est appliqué (axe Y). D'une expérimentation à l'autre (au bout d'une durée Tr) ce codage de phase évolue. Les niveaux en tirets 23 montrent la valeur que peut prendre ce codage de phase d'une expérimentation à l'autre. La description qui est faite jusqu'ici tient compte de ce que l'axe de lecture sur lequel est appliqué un gradient de lecture est l'axe X, tandis que l'axe de codage de phase est l'axe Y et que l'axe de sélection de coupe est l'axe Z. D'une manière connue ces axes peuvent voir leurs fonctionnalités d'interchangées ou même combinées pour produire des images d'orientation particulière. Ceci n'interfère pas dans le principe de l'invention.

Le calcul de reconstruction d'image est connu. Il comporte l'exécution de 2 transformées de Fourier : une dite sur $K_1$ dépendant du gradient de lecture, et une dite sur $K_2$ dépendant du gradient de codage de phase.

Au cours d'une expérimentation i, le gradient de codage est proportionnel à $i.K_2$. Dans l'invention, le pas du gradient de codage de phase proportionnel à $K_2$ est remplacé par un pas proportionnel à $k_2$, où $k_2$ est un sous-multiple de $K_2$. Par contre le nombre d'expérimentations successives est un multiple, dans la proportion inverse, de celui préalablement utilisé. Il n'est multiple que dans la mesure où on cherche à arriver à une même résolution significative des images. La figure 3 montre, avec un rapport 2 pour simplifier, que l'exploration globale du gradient de codage de phase dans un cas comme dans l'autre se fait sur une même échelle. Si Tr est la durée qui sépare deux séquences successives dans un cas et dans l'autre, la durée globale des séquences dans l'invention est tout simplement une durée multiple de la précédente.

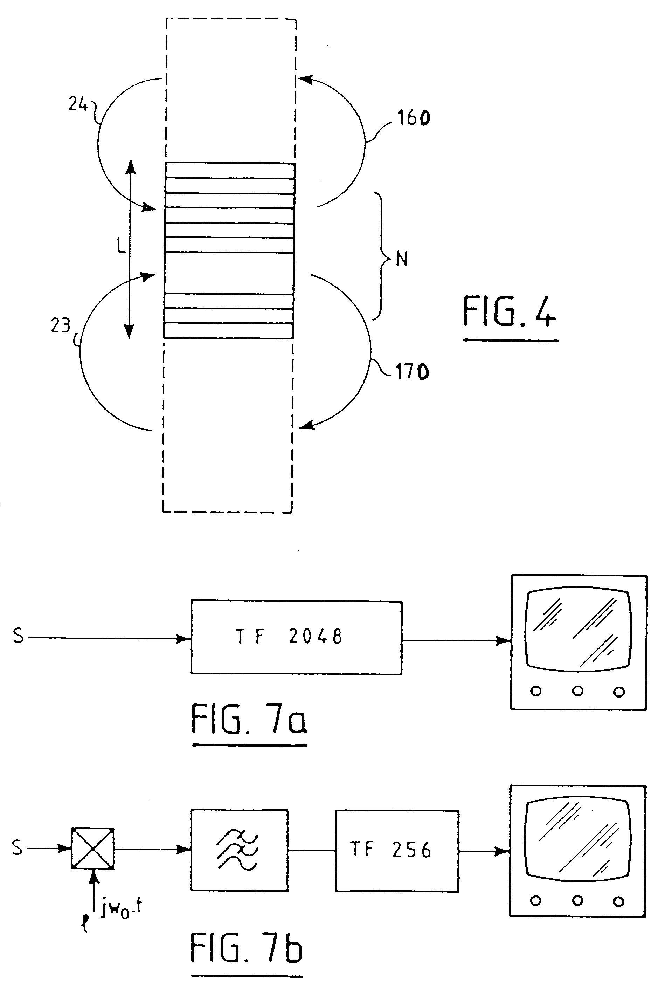

On va étudier maintenant, à l'aide des figures 4 à 6, la signification du contenu des images obtenues respectivement dans l'état de la technique et dans l'invention. La figure 4 montre le débattement d'une image de hauteur L dont la résolution comporte N lignes. L'acquisition d'une telle image d'une manière classique est obtenue avec un gradient codeur de phase $K_2$ tel que :

$$K_2 . L = 2\pi.$$

La résolution d'un instrument créateur d'images correspond en principe à la distance minimale entre deux points d'un objet que cet instrument peut séparer pour qu'ils apparaissent distinct l'un de l'autre sur les images en question. Dans l'invention, pour tenir compte du fait que les images sont toujours présentées sur des moniteurs de télévision possédant une hauteur toujours prédéterminée, on admettra que cette résolution est équivalente au nombre de lignes significatives que l'on peut présenter sur cette écran de visualisation. La résolution N dépend du nombre N de séquences effectuées. Intuitivement on conçoit que si une seule séquence est effectuée, l'image ne pourra être représentée que par une ligne. On n'aura pas discriminé dans cette image les contributions des particules situées à différentes ordonnées dans la coupe. La signification de résolution significative de l'image est liée au fait qu'il est toujours possible, mathématiquement, de produire une image sur plus que N lignes alors qu'on n'a acquis que N mesures. Cette résolution apparente obtenue n'est en fait pas plus précise que la précédente puisqu'on pourrait montrer que ce nombre supérieur de lignes n'apporte pas d'information dans l'image. Il ne correspond qu'à une simple interpolation.

Si on appelle S $(i. K_2)$ le signal de RMN reçu au cours d'une expérimentation de rang $\underline{i}$ (dans l'état de la technique cité avec $K_2$) on peut écrire que la valeur du moment magnétique M $(y_0)$ à une ordonnée $y_0$ peut être obtenu par intégrale de Fourier. Dans me approximation de cette intégrale par un calcul discret on peut écrire M $(y_0)$ de la manière suivante :

$$M(y_0) = \sum_{i=-N/2}^{i=N/2} e^{-j.i.K_2 . y_0} S(i.K_2)$$

Ce moment magnétique est en définitive représentatif de l'intensité d'un point lumineux correspondant sur l'image montrée par un écran de visualisation. L'ordonnée de ce point lumineux correspondant, en résolution significative, est telle que $y_0 = a. L/N$ où $a$ est une constante dépendant de la hauteur de l'écran. Les flèches 160 et 170 de la figure 4 montrent que pour $y_0$ extérieur à l'image L une même image est reproduite. En effet les termes $i.K_2. y_0$ dans l'expression de M $(y_0)$ sont retrouvés, par une translation de L, par une rotation de phase de 2 $\pi$. On peut montrer qu'il en est de même pour toutes les images décalées.

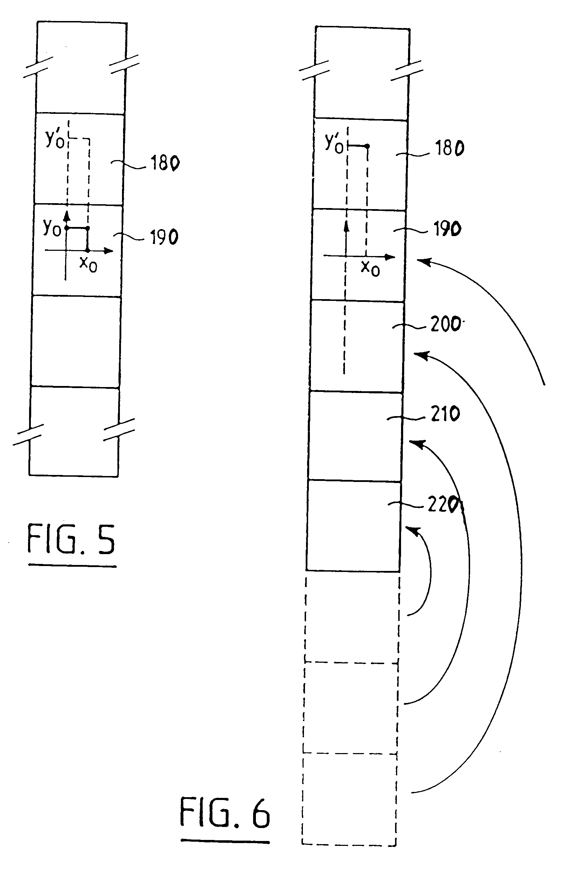

La figure 5 montre, dans les mêmes conditions que pour la figure 4, ce qu'il advient dans l'invention lorsque le pas de codage a été pris égal à un sous multiple. La valeur M $(y_0)$ se calcule exactement de la même façon sauf que l'intégration se fait sur beaucoup plus de points, dans un exemple 2 048 points. Dans ce cas M $(y_0)$ peut s'écrire de la même manière que précédemment sauf que $K_2$ est remplacé par $k_2$ et que N est remplacé par un multiple de N. Dans l'exemple ce multiple vaut 8 x 256 = 2048.

Quand $y_0$ appartient à l'intervalle de définition de L (L/2 ; -L/2) le calcul de M $(y_0)$ aboutit au même résultat que précédemment mais avec une transformée de Fourier à 2048 points au lieu d'une transformée de Fourier à 256 points. Tout au plus cette valeur est plus précisémment calculée. Par contre pour des images décalées 180 de l'image centrale 190, on peut montrer que ces images sont maintenant vierges. C'est d'une part intuitif puisque, le champ image s'étendant en dehors de l'endroit où se trouve le corps 2, les images qui correspondent à ces parties où le corps est absent doivent être vierges. On peut par ailleurs mathématiquement retrouver ce résultat en remarquant que pour ces images les moments magnétiques peuvent s'écrire sous la forme (dans l'exemple évoqué, et en remplaçant $y'_0$ par $y_0$ + 256) :

$$M(y'_0) = \sum_{i = -1024}^{i = +1024} e^{-j.i.k_2.256} . e^{-j.i.k_2.y_0} . S(i.k_2)$$

Dans cette expression on reconnait à droite les termes utilisés pour le calcul de M $(y_0)$ pondérés par un coefficient exp $(-j.i. k_2.256)$. Ce coefficient, compte tenu du fait qu'un sous multiple $k_2$ de $K_2$ (dans un exemple huit) a été choisi est équivalent à une rotation de phase de valeur $i. \pi/4$. Comme la valeur moyenne de ce coefficient est nul on peut montrer que la valeur de M $(y'_0)$ est nulle également. Donc l'image 180 est vierge.

La figure 6 montre ce qu'il advient de l'image 180 lorsqu'à l'endroit de coordonnées $x_0$ $y_0$ dans la coupe, le moment magnétique des particules qui y résident subit une évolution alternative sinusoïdale pure dont la pulsation $w_0$ est telle que

$$w_0.Tr = \pi/4$$

Cette valeur correspond exactement au sous multiple huit dans l'exemple choisi. Cette pulsation sinusoïdale peut, en première approximation, être le résultat d'une pulsation cardiaque dont iġi, pour les besoins de la cause, on a éliminé la composante continue. Si les conditions indiquées ci-dessus se présentent le signal S peut s'écrire

$$S(i.k_2) = e^{j.w0.i.Tr}$$

En replaçant cette valeur de S dans la précédente intégrale discrète de M $(y'_0)$. on se rend compte que le coéfficient exponentiel, modulé par cette valeur sinusoïdale de S, est maintenant une constante.

Il en résulte que l'image de la variation cyclique sinusoïdale pure des moments magnétiques, des particules situées à un endroit $x_0$, $y_0$ dans la coupe dans le corps 2, apparaît maintenant aux coordonnées $x_0, y'_0$ de l'image 180. Ce résultat particulièrement intéressant conduit, en étant généralisé, à représenter dans les images décalées 180,200,210,220 etc... les harmoniques des variations temporelles des valeurs des moments magnétiques. Les harmoniques sont décomposés selon une décomposition en série de Fourier du mouvement qui provoque la variation temporelle. On peut montrer que, si la pulsation du phénomène étudié n'est pas exactement telle que $w_0. Tr = \pi/4$, les images en harmoniques se déplacent verticalement dans les images 180 et 200 à 220. En pratique on s'arrange pour respecter approximativement cette contrainte en ajustant Tr.

Autrement dit si la pulsation cardiaque n'est pas constante tout au long de l'acquisition des 2048 séquences, l'image 180 sera floue. Par contre l'image 190 qui représente en définitive tout ce qui est fixe dans le corps, ou du moins la composante continue des variations des moments magnétiques des particules dans le corps, n'est pas altérée par la variation du cycle cardiaque. En résumé même si l'image 180 devient trouble, l'image 190 reste nette. On remarque par ailleurs que ce résultat est obtenue sans synchroniser. On remarque ensuite que si l'harmonique de rang trois apparait dans l'image 220 l'harmonique de rang quatre se replie sur cette image 220. L'harmonique de rang cinq se replie sur l'image 210, l'harmonique de rang six se replie sur l'image 200 et l'harmonique de rang sept se replie sur l'image 190 : celle qui nous intéresse. Cette situation est à rapprocher de l'état de la technique précédent où, figure 4, les flèches 230 et 240 montrent un repliement des images dûes au rythme fondamental dans l'image principale. Or les mouvements à prendre en considération, en particulier le mouvement cardiaque, peuvent être décomposés en des composantes d'influence décroissante avec le rang de l'harmonique auquel elles correspondent. En conclusion l'image 190 de ce qui est fixe est moins perturbée par l'harmonique sept du mouvement que ne peut l'être, dans l'état de la technique, l'image principale par le cycle fondamental de ce mouvement. Et pour obtenir l'image 190 il n'est nécessaire que de faire, dans l'exemple, 256 transformées de Fourier (correspondant aux 256 ordonnées $y_0$ utiles) à 2048 points de calcul chacune. Dans l'état de la technique on faisait 256 transformées de Fourier à 256 points de calcul chacune.

Au lieu de présenter l'image de ce qui fixe, il peut être intéressant de montrer l'image d'un harmonique donné. Dans le cas où on suppose que le rythme du mouvement étudié est constant, on peut aboutir à ce résultat de deux manières. Dans une première solution on calcule, pour l'image de l'harmonique considéré, comme indiqué jusqu'içi des transformés de Fourier avec 2048 points. En variante on démodule le signal de RMN mesuré par un signal théorique oscillant à la fréquence du phénomène qu'on veut étudier. On filtre en basse fréquence le signal démodulé et on recalcule l'image de cette harmonique avec une transformée de Fourier à 256 points de calcul simplement. Les figures 7a et 7b représentent schématiquement ces deux variantes possibles.

## Revendications

1. Procédé d'élimination d'artefacts dans une expérimentation d'imagerie par RMN, dans laquelle on met en oeuvre un procédé d'imagerie de type 2DFT avec un pas $K_2$ de codage de phase prédéterminé par une image de dimension donnée à obtenir, et avec un nombre N de séquences prédéterminé par une résolution significative attendue, caractérisé en ce qu'on modifie le pas $K_2$ de codage de phase en en prenant un sous multiplie $k_2$ et en ce qu'on multiple en correspondance le nombre des séquences, pour correspondre à une image de même résolution mais de dimension multiple selon une direction correspondante à ce codage de phase.

2. Procédé selon la revendication 1 caractérisé en ce qu'on reconstruit au moins en partie (19) l'image significative par une transformée de Fourier à un nombre de points multiple de N pour obtenir au moins une image (19) à au moins N lignes.

3. Procédé selon la revendication 2, caractérisé en ce que le procédé d'imagerie comporte un certain nombre de séquences de durée élémentaire Tr et en ce que la durée totale d'un nombre multiple de séquences consécutives est approximativement égale à un temps de cycle d'un phénomène ($w_0$) cyclique à étudier dans l'expérimentation.

4. Procédé selon la revendication 3, caractérisé en ce qu'on extrait de l'image reconstruite plusieurs images (18-22) à N lignes correspondant chacune à une composante harmonique d'une décomposition harmonique du phénomène cyclique.

5. Procédé selon la revendication 1, caractérisé en ce l'expérimentation comporte des séquences comprenant une excitation radiofréquence suivie d'une mesure du signal de RMN réémis en réponse à l'excitation, et en ce que le signal mesuré est démodulé par un signal harmonique d'un phénomène cyclique, puis filtré avant que l'image ne soit reconstruite par au moins N transformées de Fourier à N points de calcul pour obtenir au moins une image à au moins N lignes.

## Patentansprüche

1. Verfahren zur Beseitigung von Artefakten in einem NMR-Abbildungsexperiment, in dem ein Abbildungsverfahren vom 2DFT-Typ mit einer Phasenkodierungs-Schrittweite $K_2$, die für ein zu gewinnendes Bild mit vorgegebenen Abmessungen vorgegeben ist, und mit einer Anzahl N von Sequenzen, die für eine erwartete signifikante Auflösung vorgegeben ist, ausgeführt wird, dadurch gekennzeichnet, daß die Phasenkodierungs-Schrittweite $K_2$ durch Verwendung eines gemeinsamen Teilers $k_2$ verändert wird und daß die Anzahl der Sequenzen entsprechend vervielfacht wird, damit sie einem Bild mit gleicher Auflösung, jedoch mit vervielfachten Abmessungen in einer dieser Phasenkodierung entsprechenden Richtung entspricht.

2. Verfahren gemäß Anspruch 1, dadurch gekennzeichnet, daß wenigstens ein Teil (19) des signifikanten Bildes mit einer Fourier-Transformierten mit einer Anzahl von Punkten, die ein Vielfaches von N ist, rekonstruiert wird, um wenigstens ein Bild (19) mit wenigstens N Zeilen zu erhalten.

3. Verfahren gemäß Anspruch 2, dadurch gekennzeichnet, daß das Abbildungsverfahren eine bestimmte Anzahl von Sequenzen mit einer Basisdauer Tr aufweist und daß die Gesamtdauer einer vervielfachten Anzahl von aufeinanderfolgenden Sequenzen ungefähr gleich einer Zykluszeit eines im Experiment zu studierenden zyklischen Phänomens ($w_0$) ist.

4. Verfahren gemäß Anspruch 3, dadurch gekennzeichnet, daß aus dem rekonstruierten Bild eine Mehrzahl von Bildern (18-20) mit N Zeilen, die jeweils einer harmonischen Komponente einer harmonischen Zerlegung des zyklischen Phänomens entsprechen, entnommen werden.

5. Verfahren gemäß Anspruch 1, dadurch gekennzeichnet, daß das Experiment Sequenzen aufweist, die eine Hochfrequenz-Erregung, gefolgt von einer Messung des aufgrund der Erregung rückgesendeten NMR-Signals, umfaßt und daß das gemessene Signal von einem harmonischen Signal eines zyklischen Phänomens demoduliert wird und anschließend gefiltert wird, bevor das Bild durch wenigstens N Fourier-Transformierte mit N Berechnungspunkten rekonstruiert wird, um wenigstens ein Bild mit wenigstens N Zeilen zu erhalten.

## Claims

1. A method of eliminating artefacts in experimental NMR imaging, in which an imaging method of the 2DFT type is employed with a step $K_2$ of phase encoding predetermined by an image with a given dimension to be obtained, and with a number of N sequences predetermined by an expected significant resolution, characterized in that the phase encoding step $K_2$ is modified by taking a submultiple $k_2$ thereof and in that the number of sequences is multioplied correspondingly in order to correspond to an image of the same resolution but with a multiple dimension in accordance with one direction corresponding to such phase encoding.

2. The method as claimed in claim 1, characterized in that the significant image is reconstructed at least in part (19) by a Fourier transform at a number of points which is a multiple of N in order to obtain at least one image (19) with at least N lines.

3. The method as claimed in claim 2, characterized in that the said imaging method comprises a certain number of sequences with an elementary duration Tr and in that the total duration of a multiple number of the consecutive sequences is approximately equal to a cycle time of a cyclical phenomenon ($w_o$) to be studied in the experiment.

4. The method as claimed in claim 3, characterized in that from the reconstructed image a plurality of images (18 through 22) with N lines are extracted each corresponding to one harmonic component of a harmonic decomposition of the cyclical phenomenon.

5. The method as claimed in claim 1, characterized in that the experiment comprises sequences each including an RF excitation followed by a measurement of the NMR signal re-emitted in response to the excitation and in that the measured signal is demodulated by a harmonic signal of a cyclical phenomenon, then filtered before the image is reconstructed by at least N Fourier transforms with N calculation points in order to obtain an image with at least N lines.

FIG. 1

EP 0 298 850 B1

FIG.2a

FIG.2b

FIG.2c

FIG.2d

FIG. 3

FIG. 4

FIG. 7a

FIG. 7b

FIG. 5

FIG. 6